# EUROPEAN PATENT APPLICATION

(11) **EP 2 495 771 A1**
(43) Date of publication of application: **05.09.2012**
(21) Application number: 10826598.4
(22) Date of filing: 21.10.2010
(51) Int. Cl.: H01L 31/04

(54) **SOLAR CELL**

(30) Priority: 28.10.2009 JP 2009247819
(71) Applicant: Hitachi Chemical Company, Ltd., Tokyo 163-0449 (JP)
(72) Inventor: OKANIWA, Kaoru, Tsukuba-shi Ibaraki 300-4247 (JP)
(74) Representative: HOFFMANN EITLE
(86) International application number: PCT/JP2010/068564
(87) International publication number: WO 2011/052466

(57) **Abstract**

Disclosed is a solar cell wherein generation of internal stress is reduced, thereby reducing crystal defects and recombination loss. Specifically disclosed is a solar cell having an antireflective film and an external lead-out electrode on the light-receiving side of a semiconductor substrate that is provided with a p-n junction, while comprising an electrode layer on the non-light-receiving side of the semiconductor substrate. The solar cell is characterized in that the electrode layer is in the form of a solid layer and has a thickness of not more than 5 µm. It is preferable that the electrode layer has a sheet resistance of not more than 1 × 10⁻⁴ Ω/.

## Description

### TECHNICAL FIELD

The present invention relates to a solar cell, and more particularly, to a technology which can reduce the photoelectric conversion loss caused by electron-hole recombination at the crystal defects or crystal grain boundaries that are present within the polycrystalline silicon serving as semiconductor substrates, and can reduce the internal stress of polycrystalline silicon solar cells and the warpage of the cells caused thereby, and which can enhance the yield rate in the cell-module production process.

### BACKGROUND ART

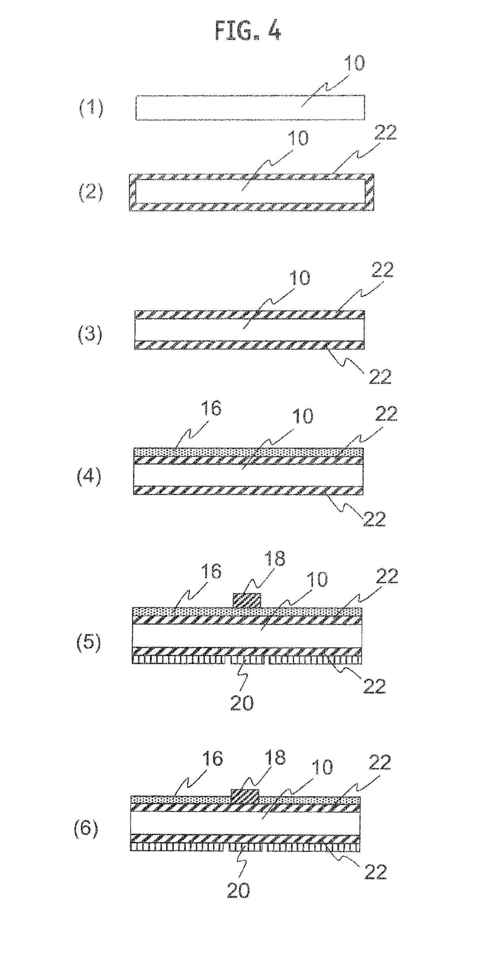

A conventional process for the production of polycrystalline silicon solar cells will be explained using FIG. 4. In FIG. 4(1), a boron-doped p-type silicon substrate 10 is treated such that a damaged layer at the silicon surface, which occurs when the substrate is sliced from a cast ingot, is removed with 20% caustic soda. Subsequently, etching is performed using a liquid mixture of 1% caustic soda and 10% isopropyl alcohol, and thus a textured structure is formed. In a solar cell, when a textured structure is formed on the light-receiving surface (front surface), the light trapping effect is accelerated, and an efficiency increase can be promoted. In FIG. 4(2), subsequently, a liquid containing P₂O₅ is applied, and the applied liquid is treated for several ten minutes at 800°C to 900°C, or treated for several ten minutes at 800°C to 900°C in a mixed gas atmosphere of phosphorus oxychloride (POCl₃), nitrogen, and oxygen. Thereby, an n-type layer 22 is formed uniformly. At this time, in the method using a phosphorus oxychloride atmosphere, the diffusion of phosphorus reaches the side surfaces and the back surface as well, so that the n-type layer is formed not only on the surface but also on the side surfaces and the back surface. Therefore, in FIG. 4(3), side etching is carried out in order to remove the n-type layer on the side surfaces. Furthermore, in FIG. 4(4), an antireflective film 16 formed from a silicon nitride film is formed on the surface of the n-type layer to a uniform thickness.

For example, a silicon nitride film is formed by a plasma CVD method which uses a gas mixture of SiH₄ and NH₃ as a raw material. At this time, hydrogen diffuses into the crystals, and those orbitals which do not take part in the bonding of silicon atoms, that is, dangling bonds, and hydrogen atoms are bonded together, thus inactivating crystal defects. As such, an operation for correcting crystal defects is referred to as hydrogen passivation, and descriptions thereon are found in, for example, Patent Document 1. Furthermore, in regard to the inactivation of defects, a method of using hydrogenated amorphous silicon has also been suggested, and descriptions thereon are found in Patent Document 2.

Next, in FIG. 4(5), a silver paste for a front surface electrode is applied by a screen printing method and dried, and thus a front surface electrode 18 is formed. At this time, the front surface electrode 18 is formed on the antireflective film. Subsequently, also for the back surface side, an aluminum paste for back surface is applied by printing and dried in the same manner as in the case of the front surface side, and thus a back surface electrode 20 is formed. At this time, a portion of the back surface is provided with a silver paste for forming a silver electrode, for the purpose of connection between cells in the module process. Furthermore, in FIG. 4(6), the electrodes are fired, and thus the assembly is completed as a solar cell. When the assembly is fired for several minutes at a temperature in the range of 600°C to 900°C, on the front surface side, the glass material contained in the silver paste causes a portion of the antireflective film, which is an insulating film, and a portion of silicon to melt along, and thus silver can be brought into ohmic contact with silicon. This process is called firing-through. On the other hand, on the back surface side, at the sites where the back surface also has the n-type layer as described above, the aluminum in the aluminum paste reacts with silicon on the back surface side to form a p-type layer, and thus a Back Surface Field (BSF) layer which improves the power generation capacity is formed.

As described in the above, in the occasion of forming the n-type layer, particularly during the gas phase reaction using phosphorus oxychloride, the n-type layer is formed not only on the surface where the n-type layer is originally needed (usually, the light-receiving surface = front surface), but also on the surface of the other side (non-light receiving surface = back surface) or side surfaces. Accordingly, in order to have a p-n junction structure as an element, side etching, as well as reconversion of the n-type layer to a p-type layer in the non-light receiving surface are needed. In the conventional processes for producing polycrystalline silicon solar cells described above, a paste of aluminum, which is a Group 13 element, is applied on the back surface and fired, and thus the n-type layer is converted again to a p-type layer.

### CITATION LIST

### PATENT DOCUMENTS

Patent Document 1: Japanese Patent Application Laid-Open (JP-A) No. 59-136926
Patent Document 2: JP-A No. 2008-251726

### SUMMARY OF THE INVENTION

### PROBLEM TO BE SOLVED BY THE INVENTION

In the process for producing polycrystalline silicon solar cells as described above, the polycrystalline silicon that constitutes substrates contains a large number of crystal defects originating from the crystal grain boundaries. These defects serve as the recombination centers for carriers such as the electrons and holes generated as a result of light irradiation of sunlight or the like, and they are causative of an electric power loss. Particularly, in the process for producing polycrystalline silicon solar cells, an aluminum paste is printed on the back surface, and this is fired so as to convert an n-type layer to a p+ layer, while at the same time, an ohmic contact is obtained. However, since the aluminum paste has low electrical conductivity, the sheet resistance must be decreased. Thus, usually, an aluminum layer should be formed over the entire surface of the back surface to obtain a thickness after firing of about 10 µm to 20 µm. Furthermore, since the coefficients of thermal expansion of silicon and aluminum are largely different from each other, such difference brings about the occurrence of a large internal stress in the silicon substrate during the processes of firing and cooling, thereby causing warpage.

This internal stress and warpage are not desirable to the characteristics of the cell itself as well as to the subsequent module production processes. That is, this stress brings damage to the crystal grain boundaries of the polycrystalline system, thus causing an increase in the number of the recombination centers described above, and causing an extension of the electric power loss. Also, warpage is likely to cause breakage of cells during the conveyance of cells in the module process or upon the connection with copper wires called tab wires. Recently, as a result of an improvement of slicing technology, the thickness of a polycrystalline silicon substrate is 170 µm, and this will become even slimmer in the near future. Thus, the substrate will tend to be more susceptible to cracking than before.

In order to attenuate such internal stress, avoiding the use of aluminum paste on the back surface may be considered. However, in the conventional production processes, such avoidance is inadequate if it is desired to reconvert an n-type layer to a p-type layer and to thereby retain the characteristics of the cell as discussed above.

Furthermore, in the process for producing polycrystalline silicon solar cells described above, since the process of printing and firing of the back surface electrode, which generates stress, is carried out only after the hydrogen passivation for making up for crystal defects is carried out, the stress generated therefrom results in an increase in the number of crystal defects again.

In addition, in the process for producing polycrystalline silicon solar cells described above, the hydrogen passivation for making up for crystal defects is carried out simultaneously at the time of forming an antireflective film. Accordingly, the hydrogen passivation treatment becomes effective only at the surface, so that in the interior of the crystals (referred to as bulk) or at the back surface, crystal defects are not treated and remain working as recombination centers.

The present invention has been made in view of the problems of the related art as described above, and the invention is intended to achieve the following objects.
An object of the present invention is to provide, in particular, a solar cell, which can reduce the occurrence of internal stress even if polycrystalline silicon substrates is used, and can thereby reduce crystal defects and recombination loss. Furthermore, the present invention is also intended to reduce a warpage that is induced by internal stress, and to reduce breakage of cells in the cell and module production processes, thereby enhancing the yield rate.

### MEANS FOR SOLVING PROBLEM

The means for solving the problems described are as follows.
(1) A solar cell having an antireflective film and an external lead-out electrode on light-receiving side of a semiconductor substrate that is provided with a p-n junction, and an electrode layer on non-light-receiving side of the semiconductor substrate,
   wherein the electrode layer is formed in a continuous form and has a thickness of 5 µm or less.

(2) The solar cell according to (1), wherein the sheet resistance of the electrode layer is 1×10⁻⁴ Ω/ or less.

(3) A solar cell having an antireflective film and an external lead-out electrode on light-receiving side of a semiconductor substrate that is provided with a p-n junction, and an electrode layer on non-light-receiving side of the semiconductor substrate,
   wherein the electrode layer is formed in a non-continuous form.

(4) The solar cell according to (3), wherein the non-continuous electrode layer is composed of a busbar electrode and a finger electrode that is intersecting with the busbar electrode.

(5) The solar cell according to (3), wherein the non-continuous electrode is a network-shaped electrode.

(6) The solar cell according to any one of (1) to (5), wherein the semiconductor substrate is formed of polycrystalline silicon.

### EFFECT OF THE INVENTION

According to the present invention, since either the thickness of a back surface electrode is made small or a back surface electrode is composed of a busbar electrode and a finger electrode that is intersecting with the busbar electrode, the occurrence of internal stress can be suppressed, and thereby, the suppression of damage in the crystal grain boundaries, the suppression of an increase in crystal defects, and a decrease in breakage during the process are made possible. Thus, it is possible to provide a solar cell that can contribute to an increase of efficiency and an increase of yield.

### BRIEF DESCRIPTION OF DRAWINGS

FIG. 1 is a cross-sectional diagram conceptually illustrating the process for producing a solar cell according to the invention;
FIG. 2 is a schematic diagram illustrating a back surface electrode composed of a busbar electrode and a finger electrode that is intersecting with the busbar electrode;
FIG. 3 is a cross-sectional diagram conceptually illustrating the process for producing a solar cell according to the invention which is not different from FIG. 1; and
FIG. 4 is a cross-sectional diagram conceptually illustrating a conventional process for producing a polycrystalline silicon solar cell.

### BEST MODES FOR CARRYING OUT THE INVENTION

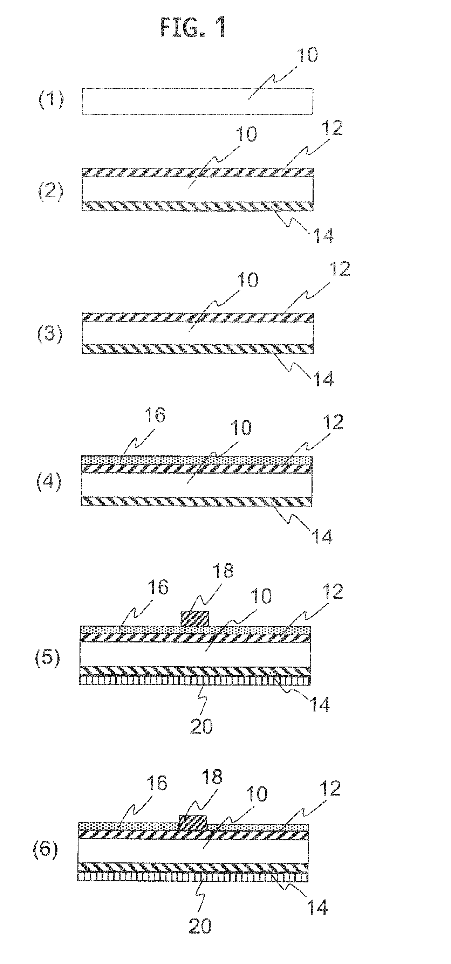

The solar cell of the first embodiment of the invention is a solar cell having an antireflective film and an external lead-out electrode on light-receiving side of a semiconductor substrate that is provided with a p-n junction, and an electrode layer ((hereinafter, sometimes referred to as "a back surface electrode layer")) on non-light-receiving side of the semiconductor substrate, wherein the electrode layer is formed in a continuous form and has a thickness of 5 µm or less.
More, the solar cell of the second embodiment of the invention is a solar cell having an antireflective film and an external lead-out electrode on light-receiving side of a semiconductor substrate that is provided with a p-n junction, and an electrode layer on non-light-receiving side of the semiconductor substrate, wherein the electrode layer is formed in a non-continuous form.
Accordingly, since the thickness of a back surface electrode layer located opposite to light-receiving side is a thin film to be 5 µm or less according to the first embodiment of the invention, or a back surface electrode layer is formed in a non-continuous form according to the second embodiment of the invention, the occurrence of internal stress can be suppressed, and thereby, the suppression of damage in the crystal grain boundaries, the suppression of an increase in crystal defects, and a decrease in breakage during the process are made possible and it contributes to an increase of efficiency and an increase of yield.
Hereinafter, the method of making the thickness of the back surface electrode layer 5 µm or less or the method of making the back surface electrode layer a non-continuous layer in the invention will be described while making reference to FIG. 1 and the solar cell of the invention will be made clear. FIG. 1 is a schematic cross-sectional diagram which conceptually illustrates the process for producing a solar cell according to a first embodiment of the invention. In FIG. 1, those constituent elements that are substantially the same as the constituent elements of FIG. 4 as described above are denoted by the same reference numerals.

FIG. 1(1) illustrates polycrystalline silicon which is a p-type semiconductor substrate as in the case of the related art, and the damage layer is removed using an alkaline solution, while a textured structure is obtained by etching, in the same manner as in the related art.

In FIG. 1(2), on the front surface, that is, on the surface which serves as a light-receiving surface, a diffusion liquid for n-type layer formation is applied so as to form an n-type layer 12. On the back surface, that is, the surface which serves as a non-light-receiving surface, a diffusion liquid for p-type layer formation is applied so as to form a p-type layer 14. Namely, in the invention, p-type layer is formed without using an aluminum paste that brings about the above-mentioned problem.
According to the invention, there are no limitations on the method for application, but examples include a printing method, a spin coating method, brush coating, a spray method, and the like. Furthermore, depending on the composition of the diffusion liquid, there are occasions in which drying of the solvent is required after the diffusion liquid is applied on the various surfaces. For this process, drying is carried out at a temperature of about 80°C to 150°C, for about 1 to 5 minutes in the case of using a hot plate, and for about 10 to 30 minutes in the case of using a furnace such as an electric furnace. These drying conditions depend on the solvent composition of the diffusion liquid, and the invention is not intended to be limited particularly to these conditions.

The diffusion liquid for n-type layer formation used herein contains a compound having a Group 15 element such as phosphorus, as an impurity which serves as a donor. Specific examples of the compound include phosphates such as P₂O₅, P(OR)₃, P(OR)₅, PO(OR)₃, and ammonium dihydrogen phosphate; AsX₃, AsX₅, As₂O₃, As₂O₅, As(OR)₃, As(OR)₅, SbX₃, SbX₅, Sb(OR)₃, Sb(OR)₅ (wherein R represents an alkyl group, an allyl group, a vinyl group, or an acyl group; and X represents a halogen atom), and the like.

Furthermore, the diffusion liquid for p-type layer formation used herein contains a simple form of a Group 13 element such as boron, or a compound having the element, as an impurity which serves as an acceptor. Specific examples of the compound include B₂, B₂O₃, B(OR)₃, Al(OR)₃, AlX₃, Ga(NO₃)₃, Ga(OR)₃, GaX₃ (wherein R represents an alkyl group, an allyl group, a vinyl group or an acyl group; and X represents a halogen atom), and the like.
However, in the invention, these impurity compounds are not specified for the diffusion liquids for n-type layer and p-type layer formation, and any kind may be used as long as the compound is capable of forming an n-type layer or a p-type layer satisfactorily among the semiconductor layers.

Also, the diffusion liquids for n-type layer and p-type layer formation contains (1) the impurity compound described above as well as (2) a binder as essential components, and optionally (3) a solvent and (4) other additives are used.

Binders of the item (2) are roughly classified into silica-based binders and organic binders. The silica-based binders and the organic binders are such that any one kind of them may be incorporated, or both kinds may all be incorporated. A silica-based binder is used to control the dopant concentration uniformity, depth and the like when the n-type layer or the p-type layer is formed, and specifically, a halogenated silane, an alkoxysilane or a condensation product thereof is used.

Examples of the halogenated silane include tetrachlorosilane, tetrabromosilane, dibromodichlorosilane, vinyltrichlorosilane, methyltrichlorosilane, ethyltrichlorosilane, diphenyldichlorosilane, diethyldichlorosilane, and the like.

Examples of a silicon alkoxide include tetraalkoxysilane, trialkoxysilane, diorgano-dialkoxysilane, and the like.

Examples of a tetraalkoxysilane include tetramethoxysilane, tetraethoxysilane, tetra-n-propoxysilane, tetraisopropoxysilane, tetra-n-butoxysilane, tetra-sec-butoxysilane, tetra-tert-butoxysilane, tetraphenoxysilane, and the like.

Examples of a trialkoxysilane include trimethoxysilane, triethoxysilane, tripropoxysilane, fluorotrimethoxysilane, fluorotriethoxysilane, metlryltrimethoxysilane, methyltriethoxysilane, methyltri-n-propoxysilane, methyltriisopropoxysilane, methyltri-n-butoxysilane, methyltriisobutoxysilane, methyltri-tert-butoxysilane, methyltriphenoxysilane, ethyltrimethoxysilane, ethyltriethoxysilane, ethyltri-n-propoxysilane, ethyltriisopropoxysilane, ethyltri-n-butoxysilane, ethyltriisobutoxysilane, ethyltri-tert-butoxysilane, ethyltriphenoxysilane, n-propyltrimethoxysilane, n-propyltriethoxysilane, n-propyltri-n-propoxysilane, n-propyltriisopropoxysilane, n-propyltri-n-butoxysilane, n-propyltriisobutoxysilane, n-propyltri-tert-butoxysilane, n-propyltriphenoxysilane, isopropyltrimethoxysilane, isopropyltriethoxysilane, isopropyltri-n-propoxysilane, isopropyltriisopropoxysilane, isopropyltri-n-butoxysilane, isopropyltriisobutoxysilane, isopropyltri-tert-butoxysilane, isopropyltriphenoxysilane, n-butyltrimethoxysilane, n-butyltriethoxysilane, n-butyltri-n-propoxysilane, n-butyltriisopropoxysilane, n-butyltri-n-butoxysilane, n-butyltriisobutoxysilane, n-butyltri-tert-butoxysilane, n-butyltriphenoxysilane, sec-butyltrimethoxysilane, sec-butyltriethoxysilane, sec-butyltri-n-propoxysilane, sec-butyltriisopropoxysilane, sec-butyltri-n-butoxysilane, sec-butyltriisobutoxysilane, sec-butyltri-tert-butoxysilane, sec-butyltriphenoxysilane, t-butyltrimethoxysilane, t-butyltriethoxysilane, t-butyltri-n-propoxysilane, t-butyltriisopropoxysilane, t-butyltri-n-butoxysilane, t-butyltriisobutoxysilane, t-butyltri-tert-butoxysilane, t-butyltriphenoxysilane, phenyltrimethoxysilane, phenyltriethoxysilane, phenyltri-n-propoxysilane, phenyltriisopropoxysilane, pllenyltri-n-butoxysilane, phenyltriisobutoxysilane, phenyltri-tert-butoxysilane, phenyltriphenoxysilane, trifluoromethyltrimethoxysilane, pentafluoroethyltrimethoxysilane, 3,3,3-trifluoropropyltrimethoxysilane, 3,3,3-trifluoropropyltriethoxysilane, and the like.

Examples of a diorganodialkoxysilane include dimethyldimethoxysilane, dimethyldiethoxysilane, dimethyldi-n-propoxysilane, dimethyldiisopropoxysilane, dimethyldi-n-butoxysilane, dimethyldi-sec-butoxysilane, dimethyldi-tert-butoxysilane, dimethyldiphenoxysilane, diethyldimethoxysilane, diethyldiethoxysilane, diethyldi-n-propoxysilane, diethyldiisopropoxysilane, diethyldi-n-butoxysilane, diethyldi-sec-butoxysilane, diethyldi-tert-butoxysilane, diethyldiphenoxysilane, di-n-propyldimethoxysilane, di-n-propyldiethoxysilane, di-n-propyldi-n-propoxysilane, di-n-propyldiisopropoxysilane, di-n-propyldi-n-butoxysilane, di-n-propyldi-sec-butoxysilane, di-n-propyldi-tert-butoxysilane, di-n-propyldiphenoxysilane, diisopropyldimethoxysilane, diisopropyldiethoxysilane, diisopropyldi-n-propoxysilane, diisopropyldiisopropoxysilane, diisopropyldi-n-butoxysilane, diisopropyldi-sec-butoxysilane, diisopropyldi-tert-butoxysilane, diisopropyldiphenoxysilane, di-n-butyldimethoxysilane, di-n-butyldiethoxysilane, di-n-butyldi-n-propoxysilane, di-n-butyldiisopropoxysilane, di-n-butyldi-n-butoxysilane, di-n-butyldi-sec-butoxysilane, di-n-butyldi-tert-butoxysilane, di-n-butyldiphenoxysilane, di-sec-butyldimethoxysilane, di-sec-butyldiethoxysilane, di-sec-butyldi-n-propoxysilane, di-sec-butyldiisopropoxysilane, di-sec-butyldi-n-butoxysilane, di-sec-butyldi-sec-butoxysilane, di-see-butyldi-tert-butoxysilane, di-sec-butyldiphenoxysilane, di-tert-butyldimethoxysilane, di-tert-butyldiethoxysilane, di-tert-butyldi-n-propoxysilane, di-tert-butyldiisopropoxysilane, di-tert-butyldi-n-butoxysilane, di-tert-butyldi-sec-butoxysilane, di-tert-butyldi-tert-butoxysilane, di-tert-butyldiphenoxysilane, diphenyldimethoxysilane, diphenyldiethoxysilane, diphenyldi-n-propoxysilane, diphenyldiisopropoxysilane, diphenyldi-n-butoxysilane, diphenyldi-sec-butoxysilane, diphenyldi-tert-butoxysilane, diphenyldiphenoxysilane, bis(3,3,3-trifluoropropyl)dimethoxysilane, methyl-(3,3,3-trifluoropropyl)dimethoxysilane, and the like.

Examples of compounds other than those described above include bis-silylalkanes and bis-silylbenzenes, such as bis(trimethoxysilyl)methane, bis(triethoxysilyl)methane, bis(tri-n-propoxysilyl)methane, bis(triisopropoxysilyl)methane, bis(trimethoxysilyl)ethane, bis(triethoxysilyl)ethane, bis(tri-n-propoxysilyl)ethane, bis(triisopropoxysilyl)ethane, bis(trimethoxysilyl)propane, bis(triethoxysilyl)propane, bis(tri-n-propoxysilyl)propane, bis(triisopropoxysilyl)propane, bis(trimethoxysilyl)benzene, bis(triethoxysilyl)benzene, bis(tri-n-propoxysilyl)benzene, bis(triisopropoxysilyl)benzene, and the like.

Further examples include hexaalkoxydisilanes such as hexamethoxydisilane, hexaethoxydisilane, hexa-n-propoxydisilane, and hexaisopropoxydisilane; and dialkyltetraalkoxydisilanes such as 1,2-dimethyltetramethoxydisilane, 1,2-dimethyltetraethoxydisilane, 1,2-dimethyltetrapropoxydisilane, and the like.

An organic binder is used primarily for the purpose of adjusting the viscosity of the coating liquid and controlling the coating film thickness, and is also used for the purpose of controlling the stability of the impurity compound and the silica-based binder. The organic binder of the invention needs to have hydrophilic groups at least in some parts and examples of the hydrophilic groups include -OH, -NH₃, -COOH, -CHO, >CO, and the like. As the organic binder, it is convenient to use high molecular weight polymers having the hydrophilic groups described above, and examples include dimethylaminoethyl (meth)acrylate polymers, polyvinyl alcohol, polyacrylamides, polyvinyl amides, polyvinyl pyrrolidone, poly(meth)acrylic acids, polyethylene oxides, polysulfonic acid, acrylamidoalkylsulfonic acid, cellulose ethers, cellulose derivatives, carboxymethyl cellulose, hydroxyethyl cellulose, gelatin, starch and starch derivatives, sodium alginates, xanthan gum, guar and guar derivatives, scleroglucan, tragacanth, dextrin derivatives, and the like.
However, when a high molecular weight polymer is used alone as the binder, there is no particular need for hydrophilicity, and the organic binder can be freely selected from acrylic acid resins, acrylic acid ester resins, butadiene resins, styrene resins, and copolymers thereof.

The (3) solvent used in the invention is required to be capable of dissolving a compound containing a Group 15 element such as phosphorus as an impurity which serves as a donor, or a simple form of a Group 13 element such as boron, or a compound containing the element, as an impurity which serves as an acceptor; and the components of the silica-based binder and/or the organic binder. A mixed solution of water and an organic solvent is used as the solvent. Examples of an organic solvent capable of dissolving the silicon alkoxide component used in the invention include aprotic solvents (2,5-dimethylformamide (DMF), tetrahydrofuran (THF), chloroform, toluene, and the like), protic solvents (alcohols such as methanol and ethanol), and the like. These may be used singly or in combination of two or more kinds.

Examples of aprotic solvents include ketone-based solvents such as acetone, methyl ethyl ketone, methyl n-propyl ketone, methyl isopropyl ketone, methyl n-butyl ketone, methyl isobutyl ketone, methyl n-pentyl ketone, methyl n-hexyl ketone, diethyl ketone, dipropyl ketone, diisobutyl ketone, trimethylnonanone, cyclohexanone, cyclopentanone, methylcyclohexanone, 2,4-pentanedione, acetonylacetone, γ-butyrolactone, and γ-valerolactone; ether-based solvents such as diethyl ether, methyl ethyl ether, methyl n-di-n-propyl ether, diisopropyl ether, tetrahydrofuran, methyltetrahydrofuran, dioxane, dimethyldioxane, ethylene glycol dimethyl ether, ethylene glycol diethyl ether, ethylene glycol di-n-propyl ether, ethylene glycol dibutyl ether, diethylene glycol dimethyl ether, diethylene glycol diethyl ether, diethylene glycol methyl ethyl ether, diethylene glycol methyl mono-n-propyl ether, diethylene glycol methyl mono-n-butyl ether, diethylene glycol di-n-propyl ether, diethylene glycol di-n-butyl ether, diethylene glycol methyl mono-n-hexyl ether, triethylene glycol dimethyl ether, triethylene glycol diethyl ether, triethylene glycol methyl ethyl ether, triethylene glycol methyl mono-n-butyl ether, triethylene glycol di-n-butyl ether, triethylene glycol methyl mono-n-hexyl ether, tetraethylene glycol dimethyl ether, tetraethylene glycol diethyl ether, tetradiethylene glycol methyl ethyl ether, tetraethylene glycol methyl mono-n-butyl ether, diethylene glycol di-n-butyl ether, tetraethylene glycol methyl mono-n-hexyl ether, tetraethylene glycol di-n-butyl ether, propylene glycol dimethyl ether, propylene glycol diethyl ether, propylene glycol di-n-propyl ether, propylene glycol dibutyl ether, dipropylene glycol dimethyl ether, dipropylene glycol diethyl ether, dipropylene glycol methyl ethyl ether, dipropylene glycol methyl mono-n-butyl ether, dipropylene glycol di-n-propyl ether, dipropylene glycol di-n-butyl ether, dipropylene glycol methyl mono-n-hexyl ether, tripropylene glycol dimethyl ether, tripropylene glycol diethyl ether, tripropylene glycol methyl ethyl ether, tripropylene glycol methyl mono-n-butyl ether, tripropylene glycol di-n-butyl ether, tripropylene glycol methyl mono-n-hexyl ether, tetrapropylene glycol dimethyl ether, tetrapropylene glycol diethyl ether, tetradipropylene glycol methyl ethyl ether, tetrapropylene glycol methyl mono-n-butyl ether, dipropylene glycol di-n-butyl ether, tetrapropylene glycol methyl mono-n-hexyl ether, and tetrapropylene glycol di-n-butyl ether; ester-based solvents such as methyl acetate, ethyl acetate, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, nonyl acetate, methyl acetoacetate, ethyl acetoacetate, diethylene glycol monomethyl ether acetate, diethylene glycol monoethyl ether acetate, diethylene glycol mono-n-butyl ether acetate, dipropylene glycol monomethyl ether acetate, dipropylene glycol monoethyl ether acetate, glycol diacetate, methoxytriglycol acetate, ethyl propionate, n-butyl propionate, i-amyl propionate, diethyl oxalate, and di-n-butyl oxalate; ether acetate-based solvents such as ethylene glycol methyl ether propionate, ethylene glycol ethyl ether propionate, ethylene glycol methyl ether acetate, ethylene glycol ethyl ether acetate, diethylene glycol methyl ether acetate, diethylene glycol ethyl ether acetate, diethylene glycol n-butyl ether acetate, propylene glycol methyl ether acetate, propylene glycol ethyl ether acetate, propylene glycol propyl ether acetate, dipropylene glycolmethyl ether acetate, and dipropylene glycol ethyl ether acetate; acetonitrile, N-methylpyrrolidinone, N-ethylpyrrolidinone, N-propylpyrrolidinone, N-butylpyrrolidinone, N-hexylpyrrolidinone, N-cyclohexylpyrrolidinone, N,N-dimethylformamide, N,N-dimethylacetamide, N,N-dimethyl sulfoxide, and the like. These may be used singly or in combination of two or more kinds.

Examples of protic solvents include alcohol-based solvents such as methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, sec-heptanol, n-octanol, 2-ethylhexanol, sec-octanol, n-nonyl alcohol, n-decanol, sec-undecyl alcohol, trimethylnonyl alcohol, sec-tetradecyl alcohol, sec-heptadecyl alcohol, phenol, cyclohexanol, methylcyclohexanol, benzyl alcohol, ethylene glycol, 1,2-propylene glycol, 1,3-butylene glycol, diethylene glycol, dipropylene glycol, triethylene glycol, and tripropylene glycol; ether-based solvents such as ethylene glycol methyl ether, ethylene glycol ethyl ether, ethylene glycol monophenyl ether, diethylene glycol monomethyl ether, diethylene glycol monoethyl ether, diethylene glycol mono-n-butyl ether, diethylene glycol mono-n-hexyl ether, ethoxy triglycol, tetraethylene glycol mono-n-butyl ether, propylene glycol monomethyl ether, dipropylene glycol monomethyl ether, dipropylene glycol monoethyl ether, and tripropylene glycol monomethyl ether; ester-based solvents such as methyl lactate, ethyl lactate, n-butyl lactate, and n-amyl lactate; and the like. From the viewpoint of storage stability, alcohol-based solvents are preferred. Among these, from the viewpoint of suppressing coating unevenness or cratering, ethanol, isopropyl alcohol, propylene glycol propyl ether and the like are preferred. These may be used singly or in combination of two or more kinds.

As the (4) other additives according to the invention, for example, in the case of using a silica-based binder as the binder component of the item (2), water and a catalyst may be used.

The catalyst may be a catalyst that is used in a sol-gel reaction of silica, and examples of this kind of catalyst include acid catalysts, alkali catalysts, metal chelate compounds, and the like.

As the acid catalysts, for example, organic acids and inorganic acids may be used. Examples of organic acids include formic acid, maleic acid, fumaric acid, phthalic acid, malonic acid, succinic acid, tartaric acid, malic acid, lactic acid, citric acid, acetic acid, propionic acid, butanoic acid, pentanoic acid, hexanoic acid, heptanoic acid, octanoic acid, nonanoic acid, decanoic acid, oxalic acid, adipic acid, sebacic acid, butyric acid, oleic acid, stearic acid, linolic acid, linoleic acid, salicylic acid, benzenesulfonic acid, benzoic acid, p-aminobenzoic acid, p-toluenesulfonic acid, methanesulfonic acid, trifluoromethanesulfonic acid, trifluoroethanesulfonic acid, and the like. Examples of inorganic acids include hydrochloric acid, phosphoric acid, nitric acid, boric acid, sulfuric acid, hydrofluoric acid, and the like. These may be used singly or in combination of two or more kinds.

As the alkali catalysts, for example, inorganic alkalis and organic alkalis may be used. Examples of inorganic alkalis include sodium hydroxide, potassium hydroxide, rubidium hydroxide, cesium hydroxide, and the like. Examples of organic alkalis include pyridine, monoethanolamine, diethanolamine, triethanolamine, dimetlrylmonoethanolamine, monomethyldiethanolamine, ammonia, tetramethylammonium hydroxide, tetraethylammonium hydroxide, tetrapropylammonium hydroxide, methylamine, ethylamine, propylamine, butylamine, pentylamine, hexylamine, heptylamine, octylamine, nonylamine, decylamine, undecylamine, dodecylamine, cyclopentylamine, cyclohexylamine, N,N-dimethylamine, N,N-diethylamine, N,N-dipropylamine, N,N-dibutylamine, N,N-dipentylamine, N,N-dihexylamine, N,N-dicyclopentylamine, N,N-dicyclohexylamine, trimethylamine, triethylamine, tripropylamine, tributylamine, tripentylamine, trihexylamine, tricyclopentylamine, tricyclohexylamine, and the like. These may be used singly or in combination of two or more kinds.

Examples of the metal chelate compounds include metal chelate compounds having titanium, such as trimethoxymono(acetylacenato)titanium, triethoxymono(acetylacenato)titanium, tri-n-propoxymono(acetylacenato)titanium, triisopropoxymono(acetylacenato)titanium, tri-n-butoxymono(acetytacenato)titanium, tri-sec-butoxymono(acetylacenato)titanium, tri-tert-butoxymono(acetytacenato)titanium, dimethoxymono(acetylacenato)titanium, diethoxydi(acetylacenato)titanium, di-n-propoxydi(acetylacenato)titanium, diisopropoxydi(acetylacenato)titanium, di-n-butoxydi(acetylacenato)titanium, di-sec-butoxydi(acetylacenato)titanium, di-tert-butoxydi(acetylacenato)titanium, monomethoxytris(acetylacenato)titanium, monoethoxytris(acetylacenato)titanium, mono-n-propoxytris(acetylacenato)titanium, monoisopropoxytris(acetylacenato)titanium, mono-n-butoxytris(acetylacenato)titanium, mono-sec-butoxytris(acetylacenato)titanium, mono-tert-butoxytris(acetylacenato)titanium, tetrakis(acetylacenato)titanium, trimethoxymono(ethylacetoacetato)titanium, triethoxymono(ethylacetoacetato)titanium, tri-n-propoxymono(ethylacetoacetato)titanium, triisopropoxymono(ethylacetoacetato)titanium, tri-n-butoxymono(ethylacetoacetato)titanium, tri-sec-butoxymono(ethylacetoacetato)titanium, tri-tert-butoxymono(ethylacetoacetato)titanium, dimethoxymono(ethylacetoacetato)titanium, diethoxydi(ethylacetoacetato)titanium, di-n-propoxydi(ethylacetoacetato)titanium, diisopropoxydi(ethylacetoacetato)titanium, di-n-butoxydi(ethylacetoacetato)titanium, di-sec-butoxydi(ethylacetoacetato)titanium, di-tert-butoxydi(ethylacetoacetato)titanium, monomethoxytris(ethylacetoacetato)titanium, monoethoxytris(ethylacetoacetato)titanium, mono-n-propoxytris(ethylacetoacetato)titanium, monoisopropoxytris(ethylacetoacetato)titanium, mono-n-butoxytris(ethylacetoacetato)titanium, mono-see-butoxytris(ethylacetoacetato)titanium, mono-tert-butoxytris(ethylacetoacetato)titanium, and tetrakis(ethylacetoacetato)titanium; compounds resulting from the substitution of the titanium of the above-described metal chelate compounds having titanium, with zirconium, aluminum or the like; and the like. These may be used singly or in combination of two or more kinds.

In FIG. 1(3), the semiconductor substrate on which the respective diffusion liquids for the n-type layer and the p-type layer have been applied is heat treated at 600°C to 1200°C, and thereby, the impurities in the semiconductor layers are diffused. Thus, the n-type layer 12 and the p-type layer 14 are obtained.

In FIG. 1(4), an antireflective film 16 is obtained by the same method as the conventional methods. That is, for example, a silicon nitride film is formed by a plasma CVD method using a gas mixture of SiH₄ and NH₃ as a raw material. At this time, hydrogen diffuses into the crystals, and those orbitals which do not take part in the bonding of silicon atoms, that is, dangling bonds, and hydrogen atoms are bonded together, thus inactivating crystal defects (hydrogen passivation).

More specifically, the antireflective film is formed under the conditions in which the flow rate ratio of the gas mixture, NH₃/SiH₄, is 0.05 to 1.0; the pressure in the reaction chamber is 0.1 Torr to 2 Torr, the temperature at the time of film forming is 300°C to 550°C; and the frequency for the discharge of plasma is 100 kHz or greater.

In FIG. 1(5), a metal paste for front surface electrode is applied by printing on the antireflective film 16 at the front surface (light-receiving surface) by a screen printing method and dried, and thereby, a front surface electrode (an external lead-out electrode) 18 is formed. Subsequently, also for the back surface side, a metal paste for back surface is applied by printing and dried in the same manner as in the case of the front surface side, and thus a back surface electrode (electrode layer) 20 is formed. Here, according to the invention, since the p-type layer has already been formed on the back surface electrode side, a process for converting the n-type layer to the p-type layer using an aluminum paste such as in the case of the conventional methods, is unnecessary, and also, there is no need to use a Group 13 element such as aluminum or the like as the back surface electrode to be formed on the p-type layer. Accordingly, the degree of freedom in the selection of the material or morphology of the back surface electrode is high, and the problems occurring when aluminum is used as in the case of the conventional methods, can be avoided. Specifically, in terms of the material of the back surface electrode, a metal other than aluminum, such as silver or copper can be used, as will be described below, and in terms of the morphology, the back surface electrode can be formed in a continuous form, or can also be formed in a non-continuous form. Examples of electrodes in a non-continuous form include an electrode composed of a busbar electrode and a finger electrode that is intersecting with the busbar electrode, a network-shaped electrode; and the like. All of these electrodes can suppress the occurrence of stress in the polycrystalline silicon substrate.

When the metal paste for back surface is applied over the entire surface it is to control the film thickness such that the film thickness after firing to be 5 µm or less. Specifically, it is preferable to control the film thickness to be 1 µm to 5 µm. Furthermore, the metal paste for back surface is preferably a metal paste with which a sufficiently low sheet resistance of 1 × 10⁻⁴ Ω/ or less is obtained even when the film thickness is 5 µm or less. For example, a metal paste which is capable of forming an electrode having low resistance may be a metal paste containing (1) a metal powder and (2) glass frits as essential components, and optionally containing (3) a resin binder, (4) other additives, and the like.

Examples of the (1) metal powder include powders of silver (Ag), copper (Cu), gold (Au), aluminum (Al), and alloys thereof. These metal powders are preferably flake-shaped or spherical-shaped, and the particle size is preferably 0.001 µm to 10.0 µm.

As the (2) glass frits, those glass frits produced by melting an inorganic oxide such as SiO₂, Bi₂O₃, PbO, B₂O₃, ZnO, V₂O₅, P₂O₅, Sb₂O₃, BaO or TeO₂ at a high temperature, cooling the molten product, and pulverizing the resultant in a ball mill or the like to adjust the size to about 10 µm, are used. At this time, the glass frits are adjusted so as to have a softening temperature that is lower than the firing temperature for the metal paste, which is 600°C to 900°C.

The (3) resin binder is not particularly limited as long as it is thermally degradable, and examples include celluloses such as methyl cellulose, ethyl cellulose, and carboxymethyl cellulose; polyvinyl alcohols; polyvinylpyrrolidones; acrylic resin; vinyl acetate-acrylic acid ester copolymers; butyral resins such as polyvinylbityral; phenol-modified alkyd resins; castor oil fatty acid-modified alkyd resins; and the like.

Examples of the (4) other additives include a sintering inhibitor, a sintering aid, a thickener, a stabilizer, a dispersant, a viscosity adjusting agent, and the like.

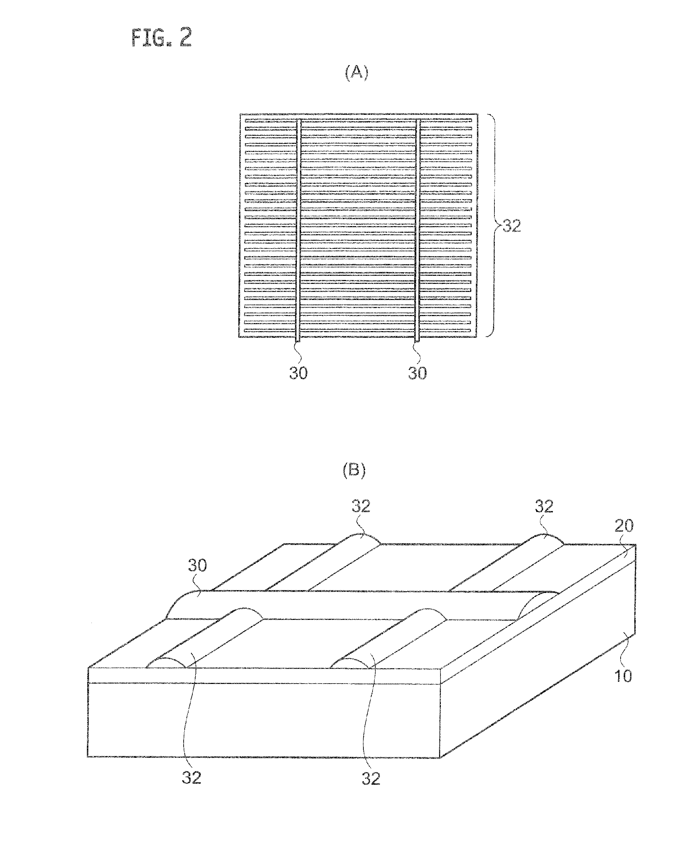

On the other hand, the back surface electrode which is composed of a busbar electrode and a finger electrode that is intersecting with the busbar electrode, will be described while making reference to FIG. 2. FIG. 2(A) is a plan view of viewing the back surface electrode from the back surface of a solar cell having a configuration composed of a busbar electrode and a finger electrode that is intersecting with the busbar electrode, while FIG. 2(B) is a perspective view illustrating a magnification of a part of FIG. 2(A). The back surface electrode of the present configuration is composed of a busbar electrode 30 and a finger electrode 32, and the back surface electrode illustrated in FIG. 2 has a configuration in which two busbar electrodes 30 are perpendicularly intersecting a number of finger electrodes 32.
Such a back surface electrode can be formed by, for examples, techniques such as screen printing of the metal paste described above, electroplating of an electrode material, and deposition of an electrode material through electron beam heating in a high vacuum environment. Among others, an electrode composed of a busbar electrode and a finger electrode is generally used as an electrode for the light-receiving side, and is therefore well known. Thus, the technique for forming the busbar electrode and the finger electrode on the light-receiving surface can be directly applied.

Meanwhile, by using the diffusion liquids (pastes) used in the invention, high concentration diffusion can be partially achieved by a selective diffusion technology in both single crystal silicon substrates and polycrystalline silicon substrates. More specifically, it can be made possible, through printing and firing, to make an n-type layer into an n++ type layer by employing a high concentration of phosphorus only in the vicinity of the metal electrode, and to also make a p-type layer into a p++ type layer in the electrode on the reverse side. Through such selective diffusion, the contact resistance can be decreased while maintaining the sheet resistance high, and thus a high efficiency solar cell is obtained.

FIG. 1(6) illustrates a solar cell in the state of being completed by firing the electrodes. When the electrodes are fired for several minutes at a temperature in the range of 600°C to 900°C, on the front surface side, the glass material included in the silver paste induces melting of the antireflective film, which is an insulating film, and further induces partial melting of the silicon surface as well. In the meantime, the silver material forms contact sites with silicon and solidifies, and thereby electrical contact is made possible. This phenomenon secures the electrical conduction between the surface silver electrode and silicon.

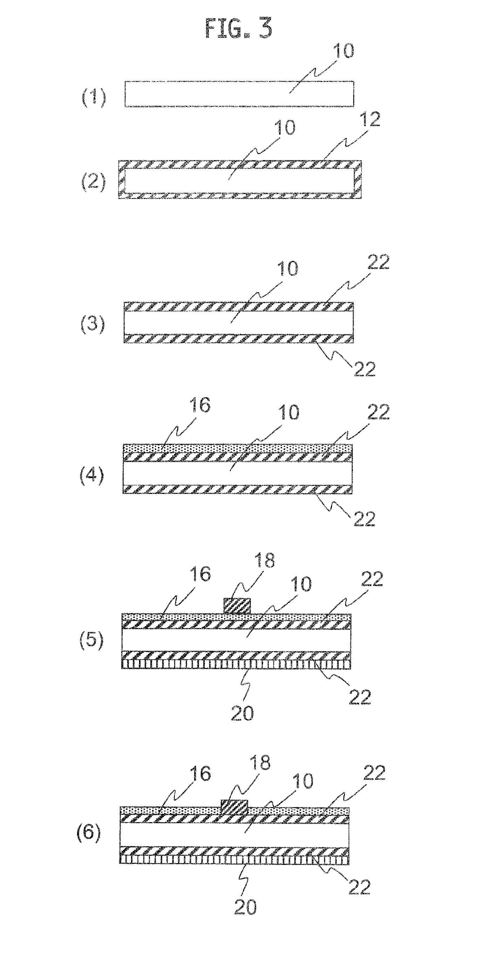

Next, other embodiment of the invention to make the thickness of a back surface electrode layer 5 µm or less will be described while making reference to FIG. 3. FIG. 3 is a schematic cross-sectional diagram conceptually illustrating the process for producing a solar cell according to the invention. The process for producing of FIG. 3 involves, in regard to the conventional production method previously described (FIG. 4), forming a p-type layer using a diffusion liquid (coating liquid for diffusion) for p-type layer formation instead of forming a p-type layer using an aluminum paste. That is, in FIG. 3, the steps of (1) to (4) are substantially the same as the conventional steps illustrated in FIG. 4. Then, in the step of (5), a metal paste for front surface electrode is applied by printing on the antireflective film 16 at the front surface (light-receiving surface) by a screen printing method and dried, and thereby, a front surface electrode 18 is formed.
Subsequently, a diffusion liquid for p-type layer formation is applied on the surface of the n-type layer 22, and the substrate is subjected to a thermal diffusion treatment to thereby reconvert the n-type layer to a p-type layer. The diffusion liquid for p-type layer formation used herein is the same as that previously described. On the surface of the diffused n-type layer 22 which has been reconverted to a p-type layer, a metal paste for back surface is applied by printing and dried in the same manner as that in FIG. 1, and thus a back surface electrode 20 is formed. At this time, particularly at the back surface, if the metal paste is applied over the entire surface as in the case of FIG. 1, the film thickness is controlled such that the film thickness after firing does not exceed 5 µm. The metal paste for back surface is the same as that previously described.

As discussed above, when the n-type layer is formed using phosphorus oxychloride, the n-type layer is formed not only on the front surface but also on the side surfaces or the back surface. However, as described in FIG. 3, since the n-type layer formed on the back surface is reconverted to a p-type layer, it is not necessary to form a back surface electrode as thick as about 10 µm to 20 µm using an aluminum paste as in the case of the conventional methods, and a back surface electrode having a thickness of 5 µm or less will suffice. Thus, the occurrence of internal stress can be suppressed.

### REFERENCE SIGNS LIST

- 10: p-Type semiconductor substrate
- 12, 22: n-Type layer
- 14: p-Type layer
- 16: Antireflective film
- 18: Front surface electrode (external lead-out electrode)
- 20: Back surface electrode (electrode layer)
- 30: Busbar electrode
- 32: Finger electrode

## Claims

1. A solar cell having an antireflective film and an external lead-out electrode on light-receiving side of a semiconductor substrate that is provided with a p-n junction, and an electrode layer on non-light-receiving side of the semiconductor substrate,
wherein the electrode layer is formed in a continuous form and has a thickness of 5 µm or less.

2. The solar cell according to claim 1, wherein the sheet resistance of the electrode layer is 1×10⁻⁴ Ω/ or less.

3. A solar cell having an antireflective film and an external lead-out electrode on light-receiving side of a semiconductor substrate that is provided with a p-n junction, and an electrode layer on non-light-receiving side of the semiconductor substrate,
wherein the electrode layer is formed in a non-continuous form.

4. The solar cell according to claim 3, wherein the non-continuous electrode layer is composed of a busbar electrode and a finger electrode that is intersecting with the busbar electrode.

5. The solar cell according to claim 3, wherein the non-continuous electrode is a network-shaped electrode.

6. The solar cell according to any one of claims 1 to 5, wherein the semiconductor substrate is formed of polycrystalline silicon.
